# EUROPEAN PATENT APPLICATION

(11) **EP 0 877 423 A2**
(43) Date of publication of application: **11.11.1998**
(21) Application number: 98303528.8
(22) Date of filing: 06.05.1998
(51) Int. Cl.: H01L 23/498, H01L 23/66

(54) **Integrated circuit package**

(30) Priority: 06.05.1997 US 45658 P
(71) Applicant: THE WHITAKER CORPORATION, Wilmington, Delaware 19808 (US)
(72) Inventor: Soshea, Eric, Westminster, MA 01473 (US); Ziegner, Bernhard, Tyngsborough, MA 01879 (US)
(74) Representative: Warren, Keith Stanley

(57) **Abstract**

An integrated circuit package has a metal carrier plate (1) and a patterned and metallized film (2) wrapped around the carrier plate. The film is metallized on one side with conductive traces (5) and on an opposite side with a conductive plane (7). The carrier plate and film are overmolded with a plastic package housing (8) exposing a portion (13) of the conductive traces (5). An IC die is disposed on the carrier plate and wirebonded to the conductive traces. A plastic cover (17) is ultrasonically welded to the housing (8) enclosing the IC die.

## Description

Expensive ceramic integrated circuit packages for microwave and millimeter wave integrated circuits ("IC") are known. IC packages of this type are typically hermetic and provide excellent performance in high frequency applications. In the interest of cost reduction, there is a need for lower cost packaging for high frequency IC's, particularly in the communications industry. Most commercial applications do not require hermetically sealed packages but reliability, low cost, and frequency performance are particularly important.

As reported in the ISHM October 1995 Proceedings, a leadframeless IC carrier package uses a metal base substrate with a polyimide film disposed thereon. The film has conductive traces patterned thereon. The metal substrate is press formed as a single piece to have a central well and a radiused edge. An IC is mounted onto the carrier central to the well and IC contacts are wirebonded to the conductive traces. A polymer is injected into the well to encapsulate it with insulating material. The radiused ends are exposed to create surface mount leads for the package. Advantageously, the IC package is appropriate for high power and high frequency devices. There remains a need, however, for an package capable of even better high frequency characteristics.

An IC package comprises leads package wherein a portion of carrier on which is disposed a film having patterned and metallized conductive traces. The carrier and the film are disposed in a package wherein a portion of the conductive traces are exposed on an exterior of the package.

Embodiments of the invention will now be described by way of example and with reference to the following drawings in which:

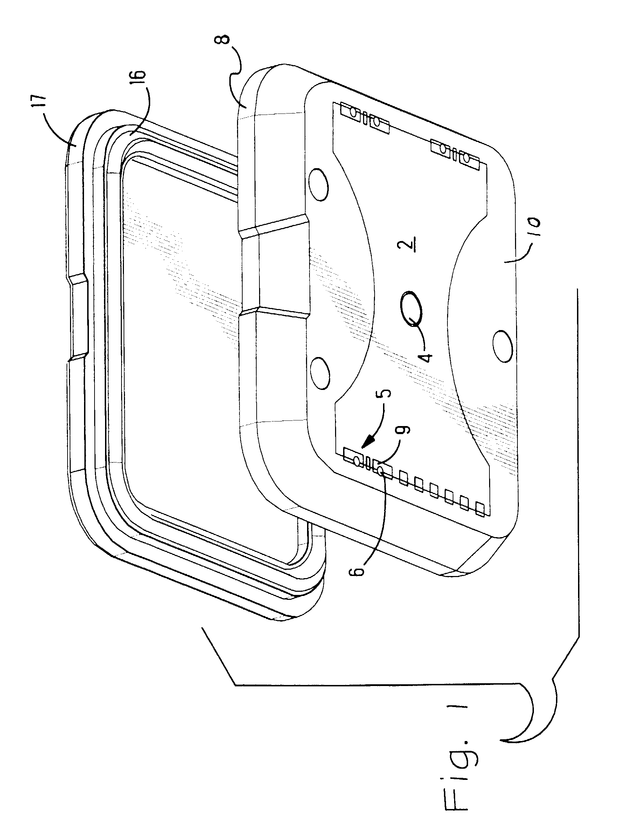

Figure 1 is a perspective view of a package housing and cover according to the teachings of the present invention.

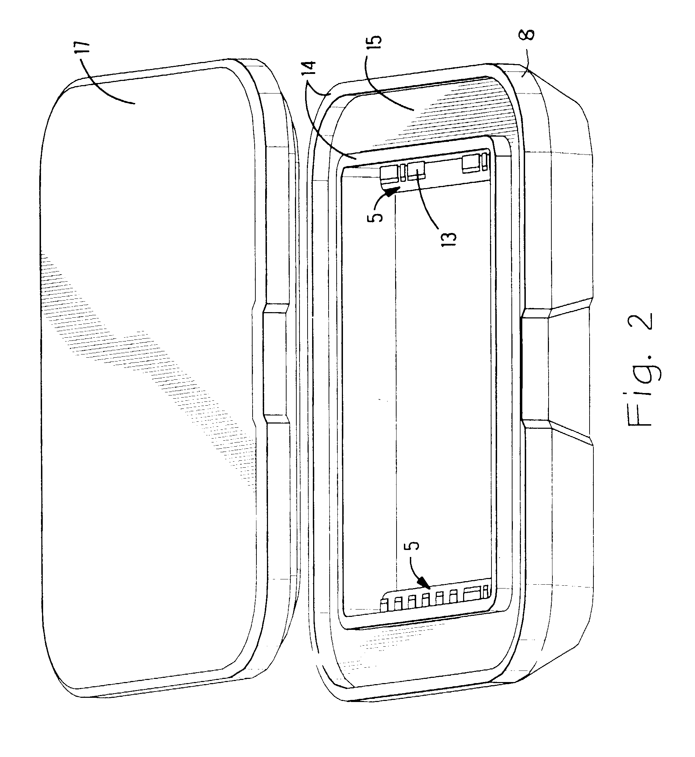

Figure 2 is a perspective view of the housing and cover shown in Figure 1 shown at a different viewing angle.

Figure 3 is an front view of a carrier according to the teachings of the present invention.

Figure 4 is a side view of the carrier shown in Figure 3.

Figure 5 is a top view of a patterned film according to the teachings of the present invention.

Figure 6 is a bottom view of a patterned film according to the teachings of the present invention.

Figure 7 is a cross sectional view of a carrier having the patterned film disposed thereon.

Figure 8 illustrates the transition of the package interconnect from an interior of the package to an exterior of the package.

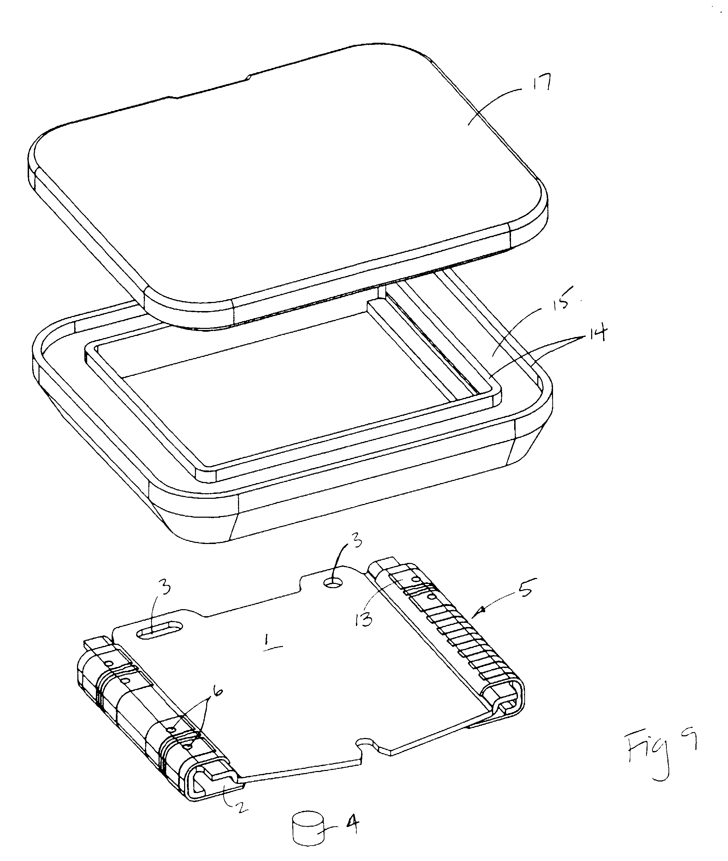

Figure 9 is an exploded perspective view of an embodiment of the invention illustrating the cover, the housing, and the film and carrier.

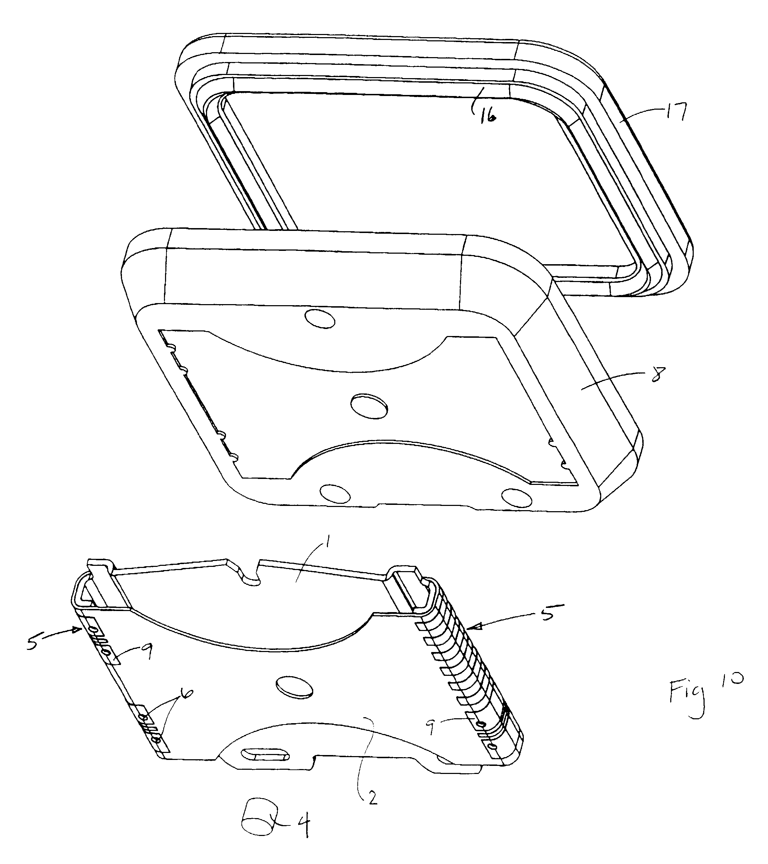

Figure 10, as shown in Figure 9 from a different viewing angle, is an exploded perspective view of an embodiment of the invention illustrating the cover, the housing, and the film and carrier.

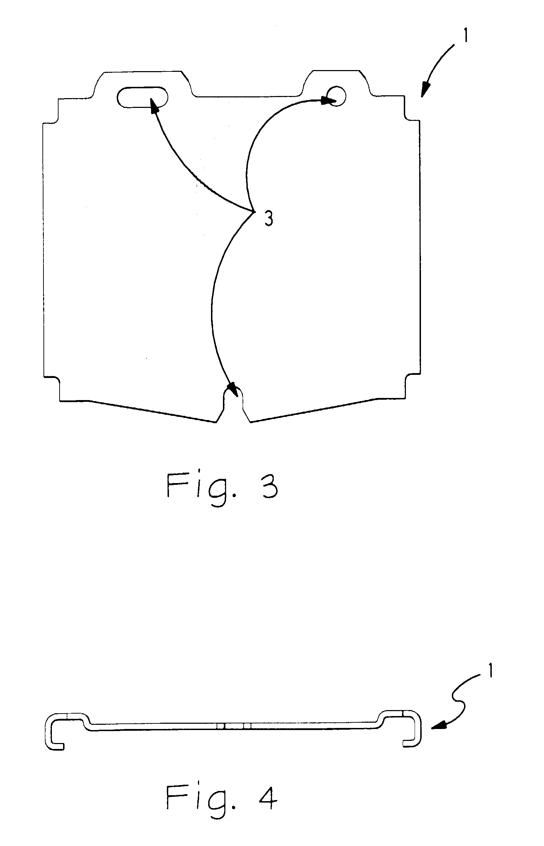

An IC package according to the teachings of the present invention comprises a stamped and formed metal carrier plate 1 over which is disposed a patterned and metallized flexible plastic film 2. The carrier plate 1 is shown in Figures 3 and 4 and is stamped from a 0.010 inch thick copper-molybdenum-copper metal laminate sheet having a 13%-74%-13% relative thickness. The carrier plate 1 disclosed is thermally matched to an IC comprising silicon and Corning 7070 glass. The carrier plate 1 further comprises three locating holes 3 which are used for location in an insert mold operation. A copper heat sink 4 is also stamped and attached to an underside of the carrier plate 1. While not necessary for operation of the package, the heat sink 4 provides for dissipation of heat generated by the IC during operation. The copper heat sink 4 is attached to the metal carrier plate 1 by a variety of known means including soldering or ultrasonic welding.

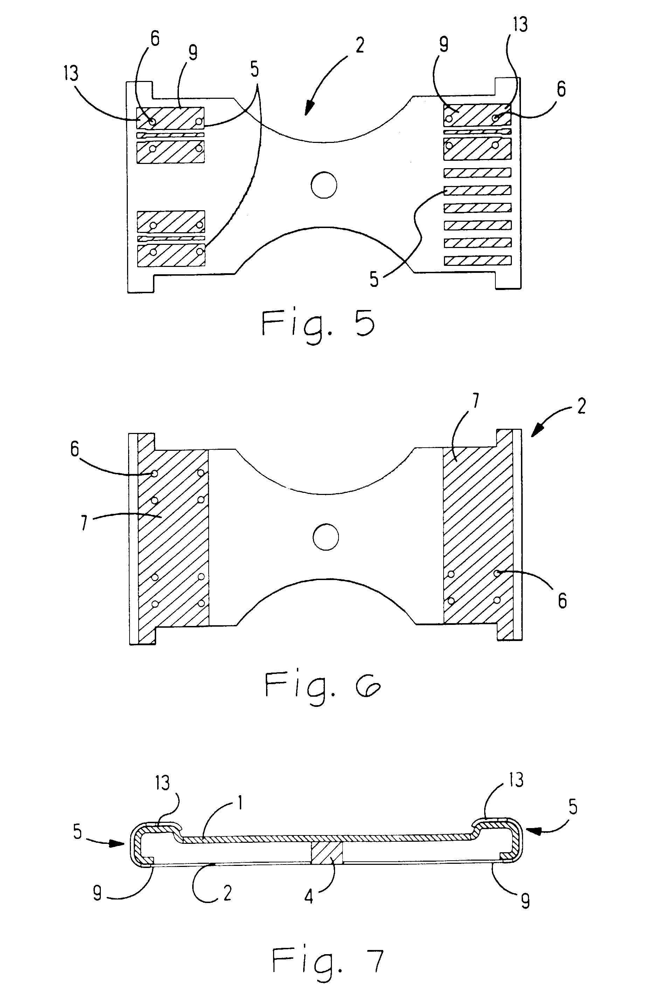

The metallized plastic film 2 shown in Figures 5 and 6 of the drawings is a 0.005 inch thick film made of ULTEM 2000(ULTEM is a registered trademark of The General Electric Corporation) with no glass fill. The metallization of the plastic film with half ounce copper is chemically etched to form interconnects 5 to generate transmission line structures at opposite ends of the film 2. On a side of the film and opposite the interconnects 5 a uniformly metallized area covers approximately the same area to create a ground plane 7 .

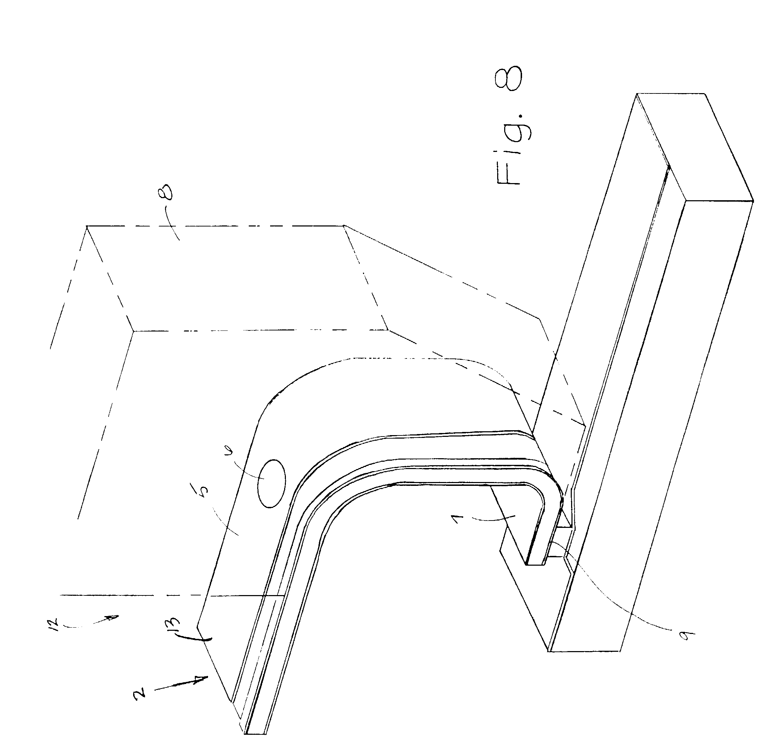

After the interconnects 5 and the ground planes 7 are patterned on the flexible film 2, via holes 6 may be plated through to electrically connect the interconnects 5 intended for ground potential with the ground plane 7. The patterned plastic film 2 is then attached to the carrier plate 1 with conductive epoxy. A cross sectional view of the patterned film 2 disposed on the carrier 1 is shown in Figure 7 of the drawings. A thermoset plastic, ULTEM 2200, a polyetherimide with 20% glass fill, is over molded around the film 2 and carrier plate 1 assembly. The locating holes 3 in the carrier plate 1 are used to position the carrier plate in a mold during the insert molding operation. After the insert mold operation, the film 2 and a mounting portion 9 of the interconnects 5 are exposed on a bottom side exterior 10 of the resultant housing 8. The mounting portion 9 of the interconnects 5 provides for surface mount attachment of the package to a printed circuit board substrate. The interconnects 5 transition through the plastic housing 8. A bonding portion 13 of the interconnects 5 are exposed on an interior 12 of the housing 8. Figure 8 of the drawings shows the transition of the interconnect through the housing 8. The housing 8 further comprises two concentric walls 14 defining a well 15 around the periphery of the housing 8. An IC is disposed on a chip mounting surface of the carrier 1 on the interior of the housing 8. Wire bonds extend from IC contacts to the bonding portion 13 of the interconnects 5 on an interior 12 of the housing or package 8.

A beneficial configuration for connection of the IC contacts to the interconnects 5 comprises a ground-signal-ground electrical configuration providing for coplanar transmission line structures. Interconnects 5 that carry DC potential need not follow the ground-signal-ground convention. The cover 17 has the same general shape of the housing and is intended to enclose the housing interior 12. The cover 17 is molded from the ULTEM 2000 plastic material and further comprises an energy concentrator 16 around the periphery of the cover 14. The concentrator 16 is placed between the concentric walls 14 of the well 15 around the periphery of the housing 8. The housing 8 and the cover 14 are then ultrasonically welded to enclose and environmentally seal the interior 12 of the package.

## Claims

1. An integrated circuit package having a carrier (1) on which is disposed a film (2) patterned with conductive traces (5) thereon, wherein a portion (9) of the conductive traces are exposed on an exterior (10) of the package, characterized in that:
at least a portion of the film (2) is also patterned with a conductive plane (7) on an opposite side of said film from the conductive traces (5) and the film is wrapped around the carrier (1) to provide a translation of the conductive planes, the carrier and the film are insert molded to create a package (8) wherein a bonding portion (13) of the conductive traces are exposed on an interior (12) of the package and a mounting portion (9) of the conductive traces are exposed on an exterior (10) of the package.

2. An IC package as recited in claim 1, wherein said carrier (1) is a stamped metal plate.

3. An IC package as recited in claim 1 or 2, and further comprising an integrated circuit die having at least one contact thereon and disposed on said carrier (1) wherein said at least one contact is electrically interconnected to said conductive traces (5).

4. An IC package as recited in claim 3, wherein said carrier (1) is made of a material that is thermally matched to said die.

5. An IC package as recited in claim 1, 2, 3, or 4 wherein said carrier (1) has parallel upper and lower planar surfaces and said film (2) and said conductive traces (5) cover at least a portion of said upper and lower carrier surfaces.

6. An IC package as recited in claim 3, 4, or 5, wherein said carrier (1) is stamped from a copper-molybdenum-copper metal laminate sheet, and said die comprises silicon and glass.

7. An IC package as recited in any preceding claim, and further comprising plated through vias (6) interconnecting at least one of said conductive traces (5) to said conductive plane (7).
